# EUROPÄISCHE PATENTSCHRIFT

(11) **EP 1 530 822 B1**
(45) Veröffentlichungstag und Bekanntmachung des Hinweises auf die Patenterteilung: **06.09.2006**
(21) Anmeldenummer: 03793654.9
(22) Anmeldetag: 28.07.2003
(51) Int. Cl.: H03M 1/00

(54) **ANORDNUNG ZUR DIGITAL-ANALOG-WANDLUNG EINES HOCHFREQUENTEN DIGITALEN EINGANGSSIGNALS IN EIN TRÄGERFREQUENTES ANALOGES AUSGANGSSIGNAL**
CONFIGURATION FOR THE DIGITAL-ANALOG CONVERSION OF A HIGH-FREQUENCY DIGITAL INPUT SIGNAL INTO A CARRIER-FREQUENCY ANALOG OUTPUT SIGNAL
SYSTEME DE CONVERSION NUMERIQUE-ANALOGIQUE D'UN SIGNAL D'ENTREE NUMERIQUE HAUTE FREQUENCE EN UN SIGNAL DE SORTIE ANALOGIQUE A FREQUENCE PORTEUSE

(30) Priorität: 19.08.2002 EP 02018602; 19.08.2002 DE 10237856
(43) Veröffentlichungstag der Anmeldung: 18.05.2005
(73) Patentinhaber: SIEMENS AKTIENGESELLSCHAFT, 80333 München (DE)
(72) Erfinder: FUCHS, Armin, 73326 Deggingen (DE); JELONNEK, Björn, 89079 Ulm (DE); WOLFF, Gunter, 89081 Ulm (DE)
(86) Internationale Anmeldenummer: PCT/EP2003/008323
(87) Internationale Veröffentlichungsnummer: WO 2004/023658

(56) Entgegenhaltungen:
- EP-A- 0 344 998
- US-A- 5 323 157
- US-A- 5 625 360
- JANSSON C ET AL: "A 1-MHz and 16-bit /spl Sigma//spl Delta/ DAC with a 224th-order reconstruction FIR-filter using only 9 nonzero taps" ASIC CONFERENCE AND EXHIBIT, 1994. PROCEEDINGS., SEVENTH ANNUAL IEEE INTERNATIONAL ROCHESTER, NY, USA 19-23 SEPT. 1994, NEW YORK, NY, USA,IEEE, 19. September 1994 (1994-09-19), Seiten 29-32, XP010140531 ISBN: 0-7803-2020-4
- PATENT ABSTRACTS OF JAPAN vol. 017, no. 531 (E-1438), 24. September 1993 (1993-09-24) & JP 05 145423 A (SONY CORP), 11. Juni 1993 (1993-06-11)

## Beschreibung

Die Erfindung betrifft eine Anordnung zur Digital-Analog-Wandlung eines hochfrequenten digitalen Eingangssignals in ein trägerfrequentes analoges Ausgangssignal gemäß dem Oberbegriff des Patentanspruchs 1.

Es sind Architekturen zur Erzeugung eines breitbandigen, trägerfrequenten Ausgangssignals bekannt, bei denen in einem niedrigen Frequenzbereich ein digitales Eingangssignal mit Hilfe eines Digital-Analog-Wandlers in ein analoges Signal gewandelt und anschließend mit Hilfe einer oder mehrerer Mischerstufen in das trägerfrequente Ausgangssignal umgesetzt wird.

Weiterhin sind Digital-Analog-Wandler-Architekturen bekannt, bei denen aus einem hochfrequenten digitalen Eingangssignal ohne weitere Frequenzumsetzung ein trägerfrequentes Ausgangssignal erzeugt wird. Das trägerfrequente analoge Ausgangssignal weist dabei neben einer gewünschten Trägerfrequenz auch unerwünschte Trägerfrequenzen auf, die beispielsweise durch ein nichtideales digitales Eingangssignal bzw. durch verschiedene unerwünschte Modulationsmechanismen entstehen können.

Bei den beschriebenen Architekturen sind stets ausgangsseitig angeordnete, kostenintensive Filter mit einer hohen Güte bzw. Mischer mit einer hohen Linearität notwendig, die jeweils auf einen gewünschten Trägerfrequenzbereich abzustimmen sind. Bei einem gewünschten Wechsel des Trägerfrequenzbereichs müssen diese kostenaufwändig ausgetauscht werden.

Aus "A 1-MHz and 16-Bit ΣΔ DAC with a 224^{th} order reconstruction FIR-Filter using only 9 nonzero taps", Jansson und Svensson, ASIC Conference and Exhibit, 1994 Proceeding, Seventh Annual IEEE International Rochester, NY, USA, 19-23. Sept. 1994, XP 010140531, Seiten 29-32, ISBN 0-7803-2020-4, ist eine Anordnung zur Digital-Analog-Wandlung bekannt, bei der ein Eingangssignal "Input" einerseits direkt und andererseits zum Teil mehrfach zeitverzögert an parallel zueinander angeordnete Stromquellen gelangt. Die Anordnung weist dabei eine FIR-Filterstruktur auf, die durch festgelegte Filterkoeffizienten c1, ..., c224 bestimmt wird.

Aus US 5,323,157 A ist ein Sigma-Delta-Digital-Analog-Wandler bekannt. Ein Signal "Input Data" wird dabei interpoliert und überabgetastet einem Sigma-Delta-Modulator mit einer Taktfrequenz MCLK zugeführt. Der Sigma-Delta-Modulator bildet ein Signal Aout, das einer mehrere D-FlipFlops umfassenden Serienschaltung zugeführt wird. Jeder inverse Ausgang eines betrachteten D-FlipFlops ist sowohl mit einem seriell nachfolgenden D-FlipFlop der Serienschaltung als auch mit einer Stromquelle verbunden. Die Stromquellen sind ausgangsseitig zusammengefasst, um ein analoges Ausgangssignal Vout zu bilden.

Es ist daher Aufgabe der vorliegenden Erfindung, eine Anordnung zur Digital-Analog-Wandlung derart auszubilden, dass sie ohne großen Aufwand auf verschiedene Trägerfrequenzbereiche abstimmbar ist.

Die Aufgabe der Erfindung wird durch die Merkmale des Anspruchs 1 gelöst. Vorteilhafte Weiterbildungen der Erfindung sind in den Unteransprüchen angegeben.

Die erfindungsgemäße Anordnung zur Digital-Analog-Wandlung weist eine integrierte Filtercharakteristik auf, wodurch ausgangsseitig kostenintensive Mischer bzw. Filter eingespart werden.

Sie besteht aus mehreren, parallel zueinander angeordneten D/A-Wandlern, wobei den einzelnen D/A-Wandlern jeweils spezifische Koeffizienten zugeordnet sind. Dadurch wird eine optimale Anpassung an einen gewünschten Trägerfrequenzbereich ermöglicht.

Die erfindungsgemäße Anordnung ist auf verschiedene Trägerfrequenzbereiche abstimmbar, indem die Taktfrequenz der D/A-Wandler entsprechend geändert wird.

Erfindungsgemäß wird durch Wahl der den D/A-Wandlern spezifisch zugeordneten Koeffizienten und der den Verzögerungsgliedern spezifisch zugeordneten Verzögerungszeiten besonders bevorzugt eine FIR-Filtercharakteristik realisiert bzw. in der Anordnung integriert. Die aufeinanderfolgenden Koeffizienten entsprechen einer Abtastung einer Impulsantwort von einem Filter, das eine gewünschte Filtercharakteristik aufweist. Dadurch weist das trägerfrequente Ausgangssignal vergleichend zu einer Realisierungsform ohne Filtercharakteristik eine höhere spektrale Reinheit auf.

Die erfindungsgemäß integrierte FIR-Filtercharkteristik ist mit Hilfe einer Taktfrequenz eines Taktsignals skalierbar. Diese kann von der Taktfrequenz der A/D-Wandler abgeleitet oder mit ihr identisch sein. Da sich die Taktfrequenz meist proportional mit der Trägerfrequenz ändert, erfolgt bei der vorliegenden Erfindung die Anpassung der Filtercharakteristik automatisch.

Bei einer Änderung des gewünschten Trägerfrequenzbereichs wird die FIR-Filtercharkterisitik über die Taktfrequenz entsprechend neu eingestellt. Ein Austausch von Hardware-Komponenten entfällt.

Entsprechen die Genauigkeit und die Anzahl der FIR-Filterkoeffizienten den Anforderungen eines neuen Mobilfunkstandards, so ist ein direktes Umschalten des Frequenzbereiches über die Taktfrequenz möglich, wobei das Umschalten mit Hilfe von Software realisierbar wäre.

Die erfindungsgemäße Anordnung ermöglicht für beliebige Trägerfrequenzbereiche, den Filteraufwand durch Vorfilterung erheblich zu minimieren. Zusammen mit einer entsprechenden Leistungsendstufe wird ein senderseitiger Verzicht auf frequenzspezifische Filter hoher Güte ermöglicht.

Mit Hilfe der erfindungsgemäßen Anordnung ist insbesondere ein durch ΣΔ-Wandler geformtes Quantisierungsrauschen des Eingangssignals leicht zu unterdrücken.

Die Filterfunktion der erfindungsgemäßen Anordnung ist durch die Signalform, die jeder D/A-Wandler pro Datum oder Bit ausgibt, beeinflussbar. Mit Hilfe einer geeigneten Signalform, wie beispielsweise Mehrfachpulsen, die aus mehreren Pulsen pro Datum bestehen, ist die Filterfunktion gezielt zu verbessern.

Im Folgenden wird ein Ausführungsbeispiel der Erfindung anhand einer Zeichnung näher erläutert. Dabei zeigt:
- FIG 1: ein Blockschaltbild einer erfindungsgemäßen Anordnung zur Digital-Analog-Wandlung, und
- FIG 2: vergleichend mit FIG 1 ein Ausführungsbeispiel einer erfindungsgemäßen Anordnung zur Digital-Analog-Wandlung.

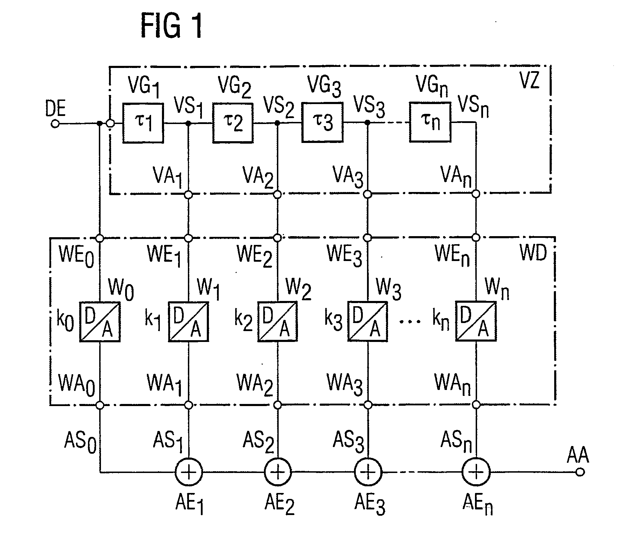

FIG 1 zeigt ein Blockschaltbild einer erfindungsgemäßen Anordnung zur Digital-Analog-Wandlung.

Ein hochfrequentes digitales Eingangssignal DE gelangt einerseits an eine Verzögerungseinrichtung VZ und andererseits an eine Wandlungseinrichtung WD.

Die Verzögerungseinrichtung VZ weist n seriell aneinandergeschaltete Verzögerungsglieder VG1, VG2, VG3, ..., VGn auf, denen jeweils eine spezifische Verzögerungszeit τ1, τ2, τ3, ..., τn zugeordnet ist. Jedes einzelne der Verzögerungsglieder VG1 bis VGn ist ausgangsseitig mit jeweils einem Ausgang VA1, VA2, VA3, ..., VAn der Verzögerungseinrichtung VZ verbunden. Über jeden dieser Ausgänge VA1 bis VAn gelangt ein diesem jeweils zugeordnetes, vom jeweiligen Verzögerungsglied VG1 bis VGn gebildetes Verzögerungssignal VS1, VS2, VS3, ..., VSn an jeweils einen Eingang WE1, WE2, WE3, ..., WEn der Wandlungseinrichtung WD.

Die Wandlungseinrichtung WD weist insgesamt n+1 D/A-Wandler W0, W1, ..., Wn auf, die zueinander parallel angeordnet sind.

Ein erster D/A-Wandler W0 erhält als Eingangssignal das digitale Eingangssignal DE über einen Eingang WE0 der Wandlungseinrichtung WD. Die anderen n D/A-Wandler erhalten über entsprechend zugeordneten Eingänge WE1 bis WEn die Verzögerungssignale VS1 bis VSn als Eingangssignal.

Jedem einzelnen der n+1 D/A-Wandler WE0 bis WEn der Wandlungseinrichtung WD ist jeweils ein spezifischer Koeffizient k0, k1, ..., kn zugeordnet.

Die einzelnen D/A-Wandler W0 bis Wn sind ausgangsseitig, beispielsweise mit Hilfe von n Addiereinrichtungen AE1, AE2, ..., AEn, zusammengefasst. Mit Hilfe der Addiereinrichtungen AE1 bis AEn werden n+1 Ausgangssignale AS0, AS1, ..., ASn der n+1 D/A-Wandler zu einem trägerfrequenten analogen Ausgangssignal AA addiert.

Zu beachten ist, dass die digitalen Eingangssignale DE und VS1 bis VSn.bei der D/A-Wandlung in den jeweiligen D/A-Wandlern W0 bis Wn mit den jeweils zugeordneten Koeffizienten k0 bis kn gewichtet werden.

Diese Koeffizienten k0 bis kn der D/A-Wandler W0 bis Wn und die Verzögerungszeiten τ1 bis τn der Verzögerungsglieder VG1 bis VGn werden dabei derart festgelegt, dass die erfindungsgemäße Anordnung zur Digital-Analog-Wandlung eine gewünschte FIR-Filtercharakteristik aufweist.

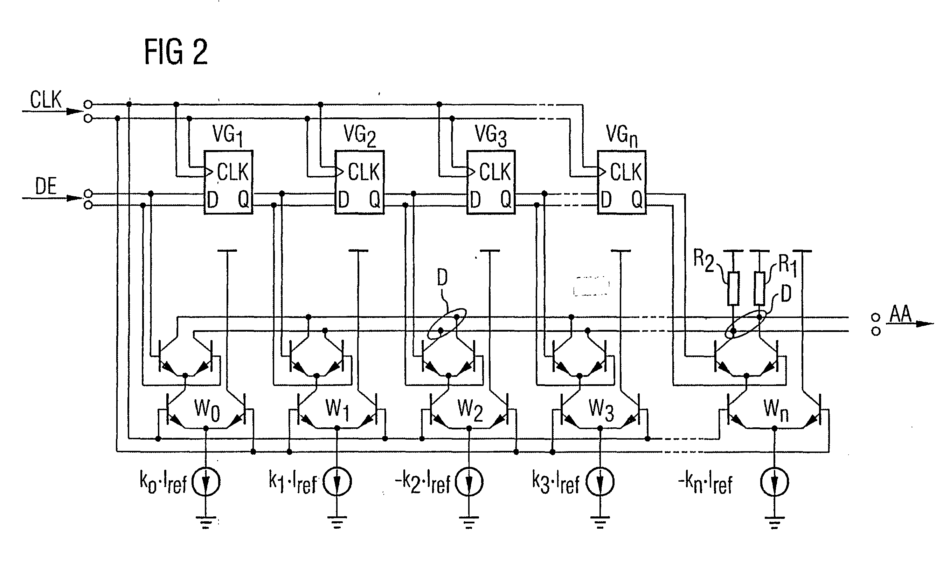

FIG 2 zeigt vergleichend mit FIG 1 ein Ausführungsbeispiel einer erfindungsgemäßen Anordnung zur Digital-Analog-Wandlung.

Die einzelnen D/A-Wandler W0 bis Wn sind als 1Bit-D/A-Wandler und die Verzögerungsglieder VG1 bis VGn als D-Latch realisiert. Sowohl die D/A-Wandler W0 bis Wn als auch die Verzögerungsglieder VG1 bis VGn sind mit einem Taktsignal CLK getaktet.

Am D-Eingang eines ersten D-Latch bzw. eines ersten Verzögerungsglieds VG1 ist das digitale Eingangssignal DE angeschaltet. Ausgangsseitig ist das erste Verzögerungsglied VG1 über seinen Q-Ausgang mit einem D-Eingang des nächsten Verzögerungsglieds VG2 verbunden, usw.

Durch das Taktsignal CLK entsprechen die den einzelnen Verzögerungsgliedern VG1 bis VGn zugeordneten spezifischen Verzögerungszeiten τ1 bis τn, wie hier dargestellt, einer halben Taktperiode des Taktsignals CLK, das ebenfalls an den D/A-Wandlern W0 bis Wn anliegt. Jedes einzelne Verzögerungsglied bzw. D-Latch verzögert um jeweils eine halbe Taktperiode.

Für die Verzögerungsglieder VG1 bis VGn sind jedoch auch kleinere Teile der Taktperiode des Taktsignals CLK verwendbar. Dadurch wird eine feinere Anpassung an eine Impulsantwort einer gewünschten Filtercharakteristik ermöglicht. Dadurch wird wiederum die Nyquistfrequenz der Filtercharakteristik vervielfacht und der Alias-Effekt unterdrückt.

Die jeweils den einzelnen D/A-Wandlern W0 bis Wn zugeordneten Koeffizienten k0 bis kn werden mit Hilfe von Referenzstromquellen kᵢ*Iref (mit i=0 bis n) eingestellt, die die Größe der Ausgangssignale AS0 bis ASn bestimmen.

Sind zur Realisierung der FIR-Filtercharakteristik negative Faktoren bei den Koeffizienten k0 bis kn erforderlich, so werden entsprechende Ausgänge bei den betroffenen D/A-Wandlern vertauscht.

Beispielhaft ist dies für die Koeffizienten k2 und kn gezeigt. Vergleichend mit dem D/A-Wandler W1 wurden bei den entsprechenden D/A-Wandlern W2 und Wn die Anschlüsse für die Ausgänge ausgetauscht - siehe jeweils Detail D.

Die Ausgangssignale AS0 bis ASn der D/A-Wandler W0 bis Wn werden zeitgleich aufsummiert und bilden das analoge Ausgangssignal AA.

Das hochfrequente digitale Eingangssignal DE kann bei der vorliegenden Erfindung auch breitbandig ausgestaltet sein.

## Patentansprüche

1. Anordnung zur Digital-Analog-Wandlung, D/A, eines hochfrequenten digitalen Eingangssignals (DE) in ein trägerfrequentes analoges Ausgangssignal (AA),
- bei der eine Verzögerungseinrichtung (VZ) mindestens ein erstes Verzögerungsglied (VG1) aufweist und weitere Verzögerungsglieder (VG2,...,VGn) dem ersten seriell aufeinanderfolgend nachgeschaltet sind,
- bei der das digitale Eingangssignal (DE) einerseits an einen Eingang des ersten Verzögerungsglieds (VG1) und andererseits an einen Eingang eines ersten D/A-Wandlers (W0) angeschaltet ist,
- bei der das erste Verzögerungsglied (VG1) ausgangsseitig mit einem Eingang eines ihm zugeordneten weiteren D/A-Wandlers (W1) verbunden ist und gegebenenfalls jedes weitere Verzögerungsglied (VG2,...,VGn) ausgangsseitig mit einem Eingang eines dem jeweiligen Verzögerungsglied (VG2,...,VGn) zugeordneten weiteren D/A-Wandlers (W2,...,Wn) verbunden ist,
- bei der alle D/A-Wandler (W0,...,Wn) mit einem identischen Taktsignal (CLK) angesteuert werden und ausgangsseitig stufenweise derart zusammengefasst sind, dass Ausgangssignale (AS0,...,ASn) aller D/A-Wandler (W0,...,Wn) das trägerfrequente analoge Ausgangssignal (AA) bilden, und
- bei der jedem D/A-Wandler (W0,...,Wn) ein spezifischer Koeffizient (k0,...,Kn) und jedem Verzögerungsglied (VG1,...,VGn) eine spezifische Verzögerungszeit (τ1,...,τn) zur Realisierung einer Filtercharakteristik zugeordnet sind,
**dadurch gekennzeichnet,**
- **dass** die den Verzögerungsgliedern (VG1,...,VGn) spezifisch zugeordneten Verzögerungszeiten (τ1,...,τn) einer vollen Taktperiode oder einer Teiltaktperiode des Taktsignals (CLK) entsprechen, und
- **dass** das Taktsignal (CLK) derart gewählt ist, dass bei einer Trägerfrequenzbereichsänderung des trägerfrequenten analogen Ausgangssignals eine automatische Anpassung der Filtercharakteristik erfolgt.

2. Anordnung nach Anspruch 1, bei der die spezifischen Koeffizienten (k0,...,kn) und die spezifischen Verzögerungszeiten (τ1,...,τn) derart gewählt sind, dass eine FIR-Filtercharakteristik realisiert wird.

3. Anordnung nach einem der vorhergehenden Ansprüche, bei der die Verzögerungsglieder (VG1,...,VGn) als mit dem Taktsignal (CLK) getaktete D-Latch ausgebildet sind.

4. Anordnung nach einem der vorhergehenden Ansprüche, bei der die D/A-Wandler (W0,...,Wn) als 1Bit-D/A-Wandler ausgebildet sind.

5. Anordnung nach einem der vorhergehenden Ansprüche, bei der die D/A-Wandler (W0,...,Wn) ausgangsseitig mittels Addiereinrichtungen (AE1,...,AEn) zusammengefasst sind.

6. Anordnung nach einem der vorhergehenden Ansprüche, bei der die den Verzögerungsgliedern (VG1,...,VGn) zugeordneten Verzögerungszeiten (τ1,...,τn) gleich sind.

7. Anordnung nach einem der vorhergehenden Ansprüche, bei der die Ausgangssignale (AS0,...,ASn) der D/A-Wandler (W0,...,Wn) zur Verbesserung der Filterfunktion jeweils eine Mehrfachpulsfolge aufweisen.

8. Anordnung nach einem der vorhergehenden Ansprüche, bei der das digitale Eingangssignal (DE) breitbandig ist.

## Claims

1. Configuration for the digital-analogue conversion, D/A, of a high-frequency digital input signal (DE) into a carrier-frequency analogue output signal (AA),
- in which a delay device (VZ) has at least one first delay element (VG1) and additional delay elements (VG2,...,VGn) connected downstream from the first in a serially consecutive manner,
- in which the digital input signal (DE) is connected to an input of the first delay element (VG1) and is connected to an input of a first D/A converter (W0),
- in which the first delay element (VG1) is connected on the output side to an input of another D/A converter (W1) assigned thereto, and, optionally, each additional delay element (VG2,...,VGn) is connected on the output side to an input of another D/A converter (W2,...,Wn) assigned to the respective delay element (VG2,...,VGn),
- in which all D/A converters (W0,...,Wn) are controlled with an identical clock signal (CLK) and are combined on the output side in a step-by-step manner so that output signals (AS0,...,ASn) of all D/A converters (W0,...,Wn) form the carrier-frequency analogue output signal (AA), and
- in which a specific coefficient (k0,...,Kn) is assigned to each D/A converter (W0,...,Wn) and a specific delay time (τ1,...,τn) is assigned to each delay element (VG2,...,VGn) for the purpose of realising a filter characteristic,
**characterised in that**
- the delay times (τ1, ..., τn) specifically assigned to the delay elements (VG1,...,VGn) correspond to an entire clock period or to part of the clock period of the clock signal (CLK), and **in that**
- the clock signal (CLK) is selected such that the filter characteristic is automatically adjusted if there is a change in carrier frequency range of the carrier-frequency analogue output signal.

2. Configuration according to Claim 1, in which the specific coefficients (k0,...,kn) and the specific delay times (τ1,...,τn) are selected such that a FIR filter characteristic is realised.

3. Configuration according to one of the above claims, in which the delay elements (VG1,...,VGn) are configured as D latches timed with the clock signal (CLK).

4. Configuration according to one of the above claims, in which the D/A converters (W0,...,Wn) are configured as 1-bit D/A converters.

5. Configuration according to one of the above claims, in which the D/A converters (W0,...,Wn) are combined on the output side by means of adding devices (AE1,...,AEn).

6. Configuration according to one of the above claims, in which the delay times (τ1,...,τn) assigned to the delay elements (VG1,...,VGn) are identical.

7. Configuration according to one of the above claims, in which the output signals (AS0,...,ASn) of the D/A converters (W0,...,Wn) each have a multiple pulse sequence in order to improve the filter function.

8. Configuration according to one of the above claims, in which the digital input signal (DE) is broadband.

## Revendications

1. Système de conversion numérique-analogique, N/A, d'un signal d'entrée numérique (DE) à haute fréquence en signal de sortie analogique (AA) à fréquence porteuse,
- dans lequel un dispositif de retard (VZ) comprend au moins un premier élément de retard (VG1) et d'autres éléments de retard (VG2, ..., VGn) sont montés sériellement l'un après l'autre à la suite du premier,
- dans lequel le signal d'entrée numérique (DE) est appliqué à une entrée du premier élément de retard (VG1) d'une part et à une entrée d'un premier convertisseur N/A (W0) d'autre part,
- dans lequel le premier élément de retard (VG1) est relié côté sortie à une entrée d'un autre convertisseur N/A (W1) qui lui est attribué et, le cas échéant, chaque autre élément de retard (VG2, ..., VGn) est relié côté sortie à une entrée d'un autre convertisseur N/A (W2, ..., Wn) attribué à l'élément de retard respectif (VG2, ..., VGn),
- dans lequel tous les convertisseurs N/A (W0, ..., Wn) sont commandés avec un signal d'horloge (CLK) identique et sont regroupés côté sortie par paliers, de manière à ce que des signaux de sortie (AS0, ..., ASn) de tous les convertisseurs N/A (W0, ..., Wn) forment le signal de sortie analogique (AA) à fréquence porteuse, et
- dans lequel est attribué à chaque convertisseur N/A (W0, ..., Wn) un coefficient spécifique (k0, ..., kn) et à chaque élément de retard (VG1, ..., VGn) un temps de retard spécifique (τ1, ..., τn) pour réaliser une caractéristique de filtre,
**caractérisé en ce que**
- les temps de retard (τ1, ..., τn) spécifiquement attribués aux éléments de retard (VG1, ..., VGn) correspondent à une période d'horloge complète ou à une période d'horloge partielle du signal d'horloge (CLK), et
- le signal d'horloge (CLK) est choisi de telle manière qu'en cas de changement de la gamme de fréquences porteuses du signal de sortie analogique à fréquence porteuse, une adaptation automatique de la caractéristique de filtre s'effectue.

2. Système selon la revendication 1, dans lequel les coefficients spécifiques (k0, ..., kn) et les temps de retard spécifiques (τ1, ..., τn) sont choisis de telle manière qu'une caractéristique de filtre FIR est réalisée.

3. Système selon l'une des revendications précédentes, dans lequel les éléments de retard (VG1, ..., VGn) sont conçus sous forme de bascule D-Latch rythmée par le signal d'horloge (CLK).

4. Système selon l'une des revendications précédentes, dans lequel les convertisseurs N/A (W0, ..., Wn) sont conçus sous forme de convertisseur N/A 1 bit.

5. Système selon l'une des revendications précédentes, dans lequel les convertisseurs N/A (W0, ..., Wn)sont réunis côté sortie au moyen de dispositifs additionneurs (AE1, ..., AEn).

6. Système selon l'une des revendications précédentes, dans lequel les temps de retard (τ1, ..., τn) attribués aux éléments de retard (VG1, ..., VGn) sont identiques.

7. Système selon l'une des revendications précédentes, dans lequel les signaux de sortie (AS0, ..., ASn) des convertisseurs N/A (W0, ..., Wn), en vue d'améliorer la fonction de filtre, présentent chacun une séquence d'impulsions multiples.

8. Système selon l'une des revendications précédentes, dans lequel le signal d'entrée numérique (DE) est à large bande.
